# EUROPEAN PATENT SPECIFICATION

(11) **EP 4 288 810 B1**
(45) Date of publication and mention of the grant of the patent: **10.06.2026**
(21) Application number: 22750644.1
(22) Date of filing: 07.02.2022
(51) Int. Cl.: G06Q 50/02, G01V 1/50, G01V 1/48, G06N 3/09, G06N 3/0499, G06F 17/18, G06N 5/04, E21B 43/40, G01V 1/28, G06N 20/00, E21B 41/00, G06Q 10/067, G06Q 10/0639, G06Q 10/0637, G06N 3/08, E21B 43/30, G01V 20/00, G06N 3/092

(54) **RESERVOIR MODELING AND WELL PLACEMENT USING MACHINE LEARNING**
RESERVOIRMODELLIERUNG UND BOHRLOCHPLATZIERUNG UNTER VERWENDUNG VON MASCHINENLERNEN
MODÉLISATION DE RÉSERVOIR ET PLACEMENT DE PUITS PAR APPRENTISSAGE AUTOMATIQUE

(30) Priority: 05.02.2021 US 202163199957 P; 05.02.2021 US 202163199958 P; 05.02.2021 US 202163199968 P; 12.02.2021 US 202163200063 P
(43) Date of publication of application: 13.12.2023
(73) Proprietor: Services Pétroliers Schlumberger, 75007 Paris (FR); GeoQuest Systems B.V., 2586 BJ The Hague (NL)
(72) Inventor: MUSTAPHA, Hussein, Abu Dhabi (AE); SU, Shi, Abu Dhabi (AE); RAMATULLAYEV, Samat, Abu Dhabi (AE); DE BRITO DIAS, Daniel, Abingdon (GB)
(74) Representative: Schlumberger Intellectual Property Department
(86) International application number: PCT/US2022/070547
(87) International publication number: WO 2022/170358

(56) References cited:
- WO-A1-2019/169073
- WO-A1-2020/172268
- WO-A1-2020/172268
- US-A1- 2014 365 409
- AMIT KUMAR: "A Machine Learning Application for Field Planning", OFFSHORE TECHNOLOGY CONFERENCE, HOUSTON, TEXAS, 1 May 2019 (2019-05-01), Houston, Texas, XP055963245, Retrieved from the Internet <URL:https://onepetro.org/OTCONF/proceedings-abstract/190TC/2-190TC/D021S026R005/180712> [retrieved on 20220921]
- HUTAHAEAN JUNKO; DEMYANOV VASILY; CHRISTIE MIKE: "Reservoir development optimization under uncertainty for infill well placement in brownfield redevelopment", JOURNAL OF PETROLEUM SCIENCE AND ENGINEERING, ELSEVIER, AMSTERDAM,, NL, vol. 175, 1 January 1900 (1900-01-01), NL , pages 444 - 464, XP085596101, ISSN: 0920-4105, DOI: 10.1016/j.petrol.2018.12.043
- KOR PEYMAN: "Decision-Driven Data Analytics for Well Placement Optimization in Field Development Scenario - Powered by Machine Learning", THESIS, UNIVERSITY OF STAVANGER, 1 June 2019 (2019-06-01), University of Stavanger, XP055963247, [retrieved on 20220921]

## Description

### Background

In conventional systems, several workflows include calibrating model parameters to select a model that accurately represents data. For instance, history matching is a process of calibrating reservoir uncertainty parameters with an objective of obtaining simulation production data as close as possible to historical data. The process is time-consuming and requires heavy computations, which pose a bottleneck for further steps in a reservoir modeling workflow.

Further, once one or more models are selected, the models may be used to design wells, drilling parameters, production plans, etc. However, given the number of models that may be simulated in order to accurately represent the reservoir, the number of potential locations for the wells, and the number of different design parameters for a well at a given location, the process of using the wells to provide useful information can take a large amount of time, expensive or potentially unavailable processing power, or both. Thus, in addition to streamlining the reservoir modeling process, systems and methods for more efficiently implementing the models to provide useful insights, e.g., for well placement analysis, would be a welcome addition.

WO 2020/172268 A1 describes a method for estimating reservoir productivity as a function of position in a subsurface volume of interest including obtaining subsurface data and well data corresponding to a subsurface volume of interest, obtaining a parameter model, using the subsurface data and the well data to generate multiple production parameter maps, applying the parameter model to the multiple production parameter maps to generate refined production parameter values and generating and displaying multiple refined production parameter graphs. A defined well design and one or more user input options are received from a user to generate limited production parameter values; generate a representation of estimated reservoir productivity as a function of position in the subsurface volume of interest using the defined well design and visual effects; and display the representation. WO 2019/169073 A1 describes a method that utilizes a probabilistic approach to identify areas of interest from multiple realizations of a reservoir model to drive well placement planning under uncertainty. A combined probability is generated from opportunity maps generated for multiple reservoir model realizations such that a probability value in various entries of the probability map represents a probability of opportunity values stored in corresponding entries of the opportunity maps meeting an opportunity criterion. One or more areas of interest may then be identified from the probability map. US2014/365409 A1 describes a method for determining well parameters for optimization of well performance. The method includes training, via a computing system, a well performance predictor based on field data corresponding to a hydrocarbon field in which a well is to be drilled, generating, via the computing system, a number of candidate well parameter combinations for the well and predicting, via the computing system, a performance of the well for each candidate well parameter combination using the trained well performance predictor. The method further includes determining, via the computing system, an optimized well parameter combination for the well such that the predicted performance of the well is maximized.

### Summary

The present invention resides in a computer-implemented method as defined in claim 1, a computer program as defined in claim 12, a computing system as defined in claim 10 and. and a non-transitory computer-readable medium as defined in claim 11.

Thus, the computing systems and methods disclosed herein are more effective methods for processing collected data that may, for example, correspond to a surface and a subsurface region. These computing systems and methods increase data processing effectiveness, efficiency, and accuracy. Such methods and computing systems may complement or replace conventional methods for processing collected data. This summary is provided to introduce a selection of concepts that are further described below in the detailed description. This summary is not intended to identify key or essential features of the claimed subject matter, nor is it intended to be used as an aid in limiting the scope of the claimed subject matter.

### Brief Description of the Drawings

The accompanying drawings, which are incorporated in and constitute a part of this specification, illustrate embodiments of the present teachings and together with the description, serve to explain the principles of the present teachings. In the figures:
Figures 1A, 1B, 1C, 1D, 2, 3A, and 3B illustrate simplified, schematic views of an oilfield and its operation, according to an embodiment.
Figure 4 illustrates a workflow for assisted history matching through optimization and machine learning, according to an embodiment.
Figure 5 illustrates an example workflow for training a proxy machine learning model, according to an embodiment.
Figure 6 is an example workflow in which the proxy machine learning model is used as a black box to reduce time and computations that would otherwise be required by an actual simulator, according to an embodiment.
Figure 7 illustrates a detailed view of an optimization workflow, according to an embodiment.
Figure 8 illustrates a flowchart of a method for selecting a classified subset of representative observations, according to an embodiment.
Figure 9 illustrates an example of one type of clustering that may be used, showing a flowchart of a method for building a machine learning model to perform clustering.
Figure 10 illustrates a flowchart of a method for drilling a well, e.g., based on a selection of a location for the well, according to an embodiment.
Figure 11 illustrates a schematic view of a computing system, according to an embodiment.

### Description of Embodiments

Reference will now be made in detail to embodiments, examples of which are illustrated in the accompanying drawings and figures. In the following detailed description, numerous specific details are set forth in order to provide a thorough understanding of the invention. However, it will be apparent to one of ordinary skill in the art that the invention may be practiced without these specific details. In other instances, well-known methods, procedures, components, circuits and networks have not been described in detail so as not to unnecessarily obscure aspects of the embodiments.

It will also be understood that, although the terms first, second, etc. may be used herein to describe various elements, these elements should not be limited by these terms. These terms are only used to distinguish one element from another. For example, a first object could be termed a second object, and, similarly, a second object could be termed a first object, without departing from the scope of the invention. The first object and the second object are both objects, respectively, but they are not to be considered the same object.

The terminology used in the description of the invention herein is for the purpose of describing particular embodiments only and is not intended to be limiting of the invention. As used in the description of the invention and the appended claims, the singular forms "a," "an" and "the" are intended to include the plural forms as well, unless the context clearly indicates otherwise. It will also be understood that the term "and/or" as used herein refers to and encompasses any possible combinations of one or more of the associated listed items. It will be further understood that the terms "includes," "including," "comprises" and/or "comprising," when used in this specification, specify the presence of stated features, integers, steps, operations, elements, and/or components, but do not preclude the presence or addition of one or more other features, integers, steps, operations, elements, components, and/or groups thereof. Further, as used herein, the term "if" may be construed to mean "when" or "upon" or "in response to determining" or "in response to detecting," depending on the context.

Attention is now directed to processing procedures, methods, techniques and workflows that are in accordance with some embodiments. Some operations in the processing procedures, methods, techniques and workflows disclosed herein may be combined and/or the order of some operations may be changed. The illustrations presented herein are in the context of oilfield operations. However, it will be appreciated that embodiments of the present disclosure may be readily tailored for use in other applications in which characterization of the subsurface is helpful. For example, building structures, such as wind farms and solar arrays, may employ such subsurface characterization efforts. Likewise, geothermal applications may employ embodiments of the present applications.

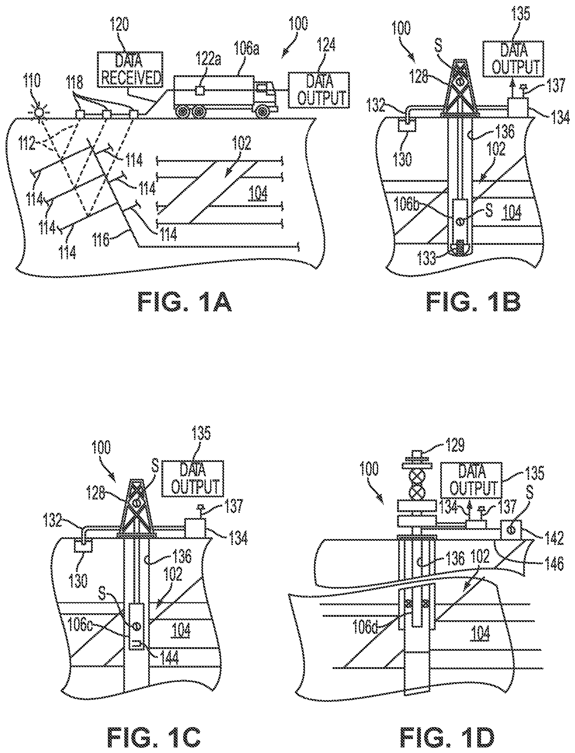

Figures 1A-1D illustrate simplified, schematic views of oilfield 100 having subterranean formation 102 containing reservoir 104 therein in accordance with implementations of various technologies and techniques described herein. Figure 1A illustrates a survey operation being performed by a survey tool, such as seismic truck 106a, to measure properties of the subterranean formation. The survey operation is a seismic survey operation for producing sound vibrations. In Figure 1A, one such sound vibration, e.g., sound vibration 112 generated by source 110, reflects off horizons 114 in earth formation 116. A set of sound vibrations is received by sensors, such as geophone-receivers 118, situated on the earth's surface. The data received 120 is provided as input data to a computer 122a of a seismic truck 106a, and responsive to the input data, computer 122a generates seismic data output 124. This seismic data output may be stored, transmitted or further processed as desired, for example, by data reduction.

Figure 1B illustrates a drilling operation being performed by drilling tools 106b suspended by rig 128 and advanced into subterranean formations 102 to form wellbore 136. Mud pit 130 is used to draw drilling mud into the drilling tools via flow line 132 for circulating drilling mud down through the drilling tools, then up wellbore 136 and back to the surface. The drilling mud is typically filtered and returned to the mud pit. A circulating system may be used for storing, controlling, or filtering the flowing drilling mud. The drilling tools are advanced into subterranean formations 102 to reach reservoir 104. Each well may target one or more reservoirs. The drilling tools are adapted for measuring downhole properties using logging while drilling tools. The logging while drilling tools may also be adapted for taking core sample 133 as shown.

Computer facilities may be positioned at various locations about the oilfield 100 (e.g., the surface unit 134) and/or at remote locations. Surface unit 134 may be used to communicate with the drilling tools and/or offsite operations, as well as with other surface or downhole sensors. Surface unit 134 is capable of communicating with the drilling tools to send commands to the drilling tools, and to receive data therefrom. Surface unit 134 may also collect data generated during the drilling operation and produce data output 135, which may then be stored or transmitted.

Sensors (S), such as gauges, may be positioned about oilfield 100 to collect data relating to various oilfield operations as described previously. As shown, sensor (S) is positioned in one or more locations in the drilling tools and/or at rig 128 to measure drilling parameters, such as weight on bit, torque on bit, pressures, temperatures, flow rates, compositions, rotary speed, and/or other parameters of the field operation. Sensors (S) may also be positioned in one or more locations in the circulating system.

Drilling tools 106b may include a bottom hole assembly (BHA) (not shown), generally referenced, near the drill bit (e.g., within several drill collar lengths from the drill bit). The bottom hole assembly includes capabilities for measuring, processing, and storing information, as well as communicating with surface unit 134. The bottom hole assembly further includes drill collars for performing various other measurement functions.

The bottom hole assembly may include a communication subassembly that communicates with surface unit 134. The communication subassembly is adapted to send signals to and receive signals from the surface using a communications channel such as mud pulse telemetry, electro-magnetic telemetry, or wired drill pipe communications. The communication subassembly may include, for example, a transmitter that generates a signal, such as an acoustic or electromagnetic signal, which is representative of the measured drilling parameters. It will be appreciated by one of skill in the art that a variety of telemetry systems may be employed, such as wired drill pipe, electromagnetic or other known telemetry systems.

Typically, the wellbore is drilled according to a drilling plan that is established prior to drilling. The drilling plan typically sets forth equipment, pressures, trajectories and/or other parameters that define the drilling process for the wellsite. The drilling operation may then be performed according to the drilling plan. However, as information is gathered, the drilling operation may need to deviate from the drilling plan. Additionally, as drilling or other operations are performed, the subsurface conditions may change. The earth model may also need adjustment as new information is collected

The data gathered by sensors (S) may be collected by surface unit 134 and/or other data collection sources for analysis or other processing. The data collected by sensors (S) may be used alone or in combination with other data. The data may be collected in one or more databases and/or transmitted on or offsite. The data may be historical data, real time data, or combinations thereof. The real time data may be used in real time, or stored for later use. The data may also be combined with historical data or other inputs for further analysis. The data may be stored in separate databases, or combined into a single database.

Surface unit 134 may include transceiver 137 to allow communications between surface unit 134 and various portions of the oilfield 100 or other locations. Surface unit 134 may also be provided with or functionally connected to one or more controllers (not shown) for actuating mechanisms at oilfield 100. Surface unit 134 may then send command signals to oilfield 100 in response to data received. Surface unit 134 may receive commands via transceiver 137 or may itself execute commands to the controller. A processor may be provided to analyze the data (locally or remotely), make the decisions and/or actuate the controller. In this manner, oilfield 100 may be selectively adjusted based on the data collected. This technique may be used to optimize (or improve) portions of the field operation, such as controlling drilling, weight on bit, pump rates, or other parameters. These adjustments may be made automatically based on computer protocol, and/or manually by an operator. In some cases, well plans may be adjusted to select optimum (or improved) operating conditions, or to avoid problems.

Figure 1C illustrates a wireline operation being performed by wireline tool 106c suspended by rig 128 and into wellbore 136 of Figure 1B. Wireline tool 106c is adapted for deployment into wellbore 136 for generating well logs, performing downhole tests and/or collecting samples. Wireline tool 106c may be used to provide another method and apparatus for performing a seismic survey operation. Wireline tool 106c may, for example, have an explosive, radioactive, electrical, or acoustic energy source 144 that sends and/or receives electrical signals to surrounding subterranean formations 102 and fluids therein.

Wireline tool 106c may be operatively connected to, for example, geophones 118 and a computer 122a of a seismic truck 106a of Figure 1A. Wireline tool 106 may also provide data to surface unit 134. Surface unit 134 may collect data generated during the wireline operation and may produce data output 135 that may be stored or transmitted. Wireline tool 106c may be positioned at various depths in the wellbore 136 to provide a survey or other information relating to the subterranean formation 102.

Sensors (S), such as gauges, may be positioned about oilfield 100 to collect data relating to various field operations as described previously. As shown, sensor S is positioned in wireline tool 106c to measure downhole parameters which relate to, for example porosity, permeability, fluid composition and/or other parameters of the field operation.

Figure 1D illustrates a production operation being performed by production tool 106d deployed from a production unit or Christmas tree 129 and into completed wellbore 136 for drawing fluid from the downhole reservoirs into surface facilities 142. The fluid flows from reservoir 104 through perforations in the casing (not shown) and into production tool 106d in wellbore 136 and to surface facilities 142 via gathering network 146.

Sensors (S), such as gauges, may be positioned about oilfield 100 to collect data relating to various field operations as described previously. As shown, the sensor (S) may be positioned in production tool 106d or associated equipment, such as Christmas tree 129, gathering network 146, surface facility 142, and/or the production facility, to measure fluid parameters, such as fluid composition, flow rates, pressures, temperatures, and/or other parameters of the production operation.

Production may also include injection wells for added recovery. One or more gathering facilities may be operatively connected to one or more of the wellsites for selectively collecting downhole fluids from the wellsite(s).

While Figures 1B-1D illustrate tools used to measure properties of an oilfield, it will be appreciated that the tools may be used in connection with non-oilfield operations, such as gas fields, mines, aquifers, storage or other subterranean facilities. Also, while certain data acquisition tools are depicted, it will be appreciated that various measurement tools capable of sensing parameters, such as seismic two-way travel time, density, resistivity, production rate, etc., of the subterranean formation and/or its geological formations may be used. Various sensors (S) may be located at various positions along the wellbore and/or the monitoring tools to collect and/or monitor the desired data. Other sources of data may also be provided from offsite locations.

The field configurations of Figures 1A-1D are intended to provide a brief description of an example of a field usable with oilfield application frameworks. Part of, or the entirety, of oilfield 100 may be on land, water and/or sea. Also, while a single field measured at a single location is depicted, oilfield applications may be utilized with any combination of one or more oilfields, one or more processing facilities and one or more wellsites.

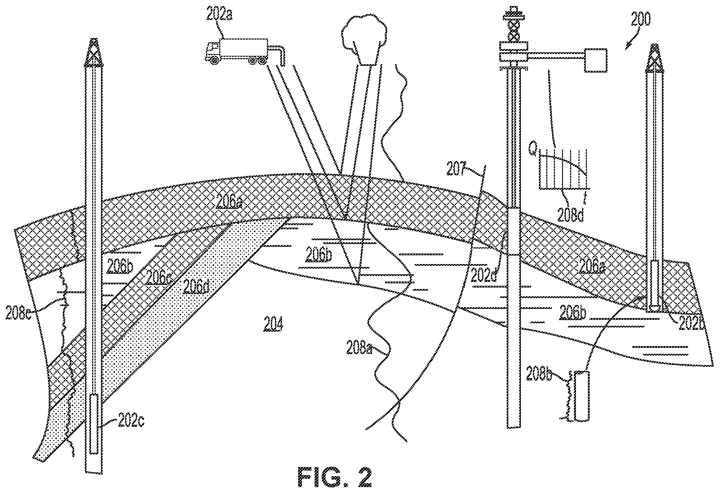

Figure 2 illustrates a schematic view, partially in cross section of oilfield 200 having data acquisition tools 202a, 202b, 202c and 202d positioned at various locations along oilfield 200 for collecting data of subterranean formation 204 in accordance with implementations of various technologies and techniques described herein. Data acquisition tools 202a-202d may be the same as data acquisition tools 106a-106d of Figures 1A-1D, respectively, or others not depicted. As shown, data acquisition tools 202a-202d generate data plots or measurements 208a-208d, respectively. These data plots are depicted along oilfield 200 to demonstrate the data generated by the various operations.

Data plots 208a-208c are examples of static data plots that may be generated by data acquisition tools 202a-202c, respectively; however, it should be understood that data plots 208a-208c may also be data plots that are updated in real time. These measurements may be analyzed to better define the properties of the formation(s) and/or determine the accuracy of the measurements and/or for checking for errors. The plots of each of the respective measurements may be aligned and scaled for comparison and verification of the properties.

Static data plot 208a is a seismic two-way response over a period of time. Static plot 208b is core sample data measured from a core sample of the formation 204. The core sample may be used to provide data, such as a graph of the density, porosity, permeability, or some other physical property of the core sample over the length of the core. Tests for density and viscosity may be performed on the fluids in the core at varying pressures and temperatures. Static data plot 208c is a logging trace that typically provides a resistivity or other measurement of the formation at various depths.

A production decline curve or graph 208d is a dynamic data plot of the fluid flow rate over time. The production decline curve typically provides the production rate as a function of time. As the fluid flows through the wellbore, measurements are taken of fluid properties, such as flow rates, pressures, composition, etc.

Other data may also be collected, such as historical data, user inputs, economic information, and/or other measurement data and other parameters of interest. As described below, the static and dynamic measurements may be analyzed and used to generate models of the subterranean formation to determine characteristics thereof. Similar measurements may also be used to measure changes in formation aspects over time.

The subterranean structure 204 has a plurality of geological formations 206a-206d. As shown, this structure has several formations or layers, including a shale layer 206a, a carbonate layer 206b, a shale layer 206c and a sand layer 206d. A fault 207 extends through the shale layer 206a and the carbonate layer 206b. The static data acquisition tools are adapted to take measurements and detect characteristics of the formations.

While a specific subterranean formation with specific geological structures is depicted, it will be appreciated that oilfield 200 may contain a variety of geological structures and/or formations, sometimes having extreme complexity. In some locations, typically below the water line, fluid may occupy pore spaces of the formations. Each of the measurement devices may be used to measure properties of the formations and/or its geological features. While each acquisition tool is shown as being in specific locations in oilfield 200, it will be appreciated that one or more types of measurement may be taken at one or more locations across one or more fields or other locations for comparison and/or analysis.

The data collected from various sources, such as the data acquisition tools of Figure 2, may then be processed and/or evaluated. Typically, seismic data displayed in static data plot 208a from data acquisition tool 202a is used by a geophysicist to determine characteristics of the subterranean formations and features. The core data shown in static plot 208b and/or log data from well log 208c are typically used by a geologist to determine various characteristics of the subterranean formation. The production data from graph 208d is typically used by the reservoir engineer to determine fluid flow reservoir characteristics. The data analyzed by the geologist, geophysicist and the reservoir engineer may be analyzed using modeling techniques.

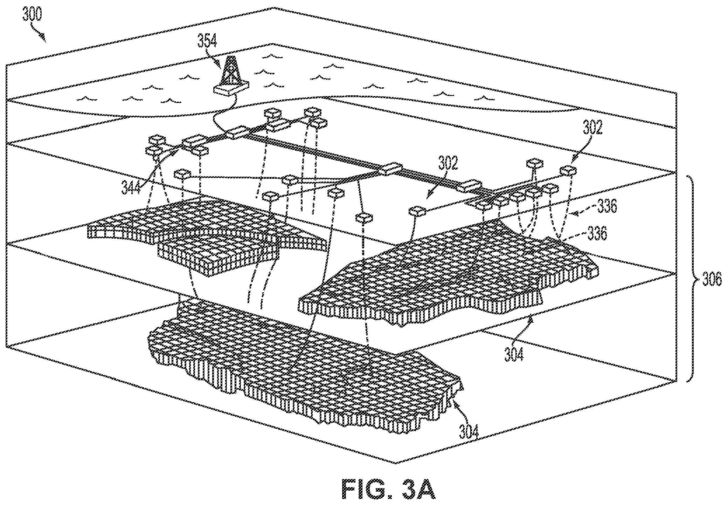

Figure 3A illustrates an oilfield 300 for performing production operations in accordance with implementations of various technologies and techniques described herein. As shown, the oilfield has a plurality of wellsites 302 operatively connected to central processing facility 354. The oilfield configuration of Figure 3A is not intended to limit the scope of the oilfield application system. Part, or all, of the oilfield may be on land and/or sea. Also, while a single oilfield with a single processing facility and a plurality of wellsites is depicted, any combination of one or more oilfields, one or more processing facilities and one or more wellsites may be present.

Each wellsite 302 has equipment that forms wellbore 336 into the earth. The wellbores extend through subterranean formations 306 including reservoirs 304. These reservoirs 304 contain fluids, such as hydrocarbons. The wellsites draw fluid from the reservoirs and pass them to the processing facilities via surface networks 344. The surface networks 344 have tubing and control mechanisms for controlling the flow of fluids from the wellsite to processing facility 354.

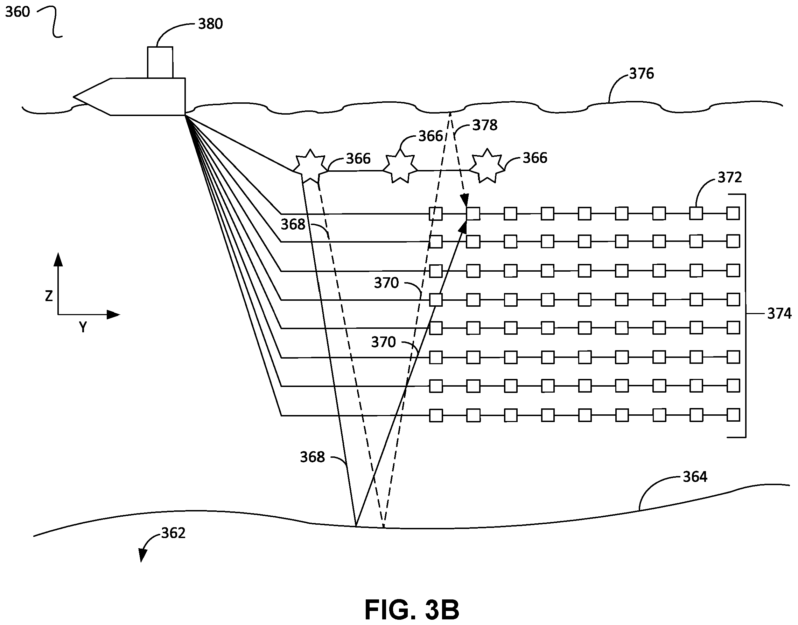

Attention is now directed to Figure 3B, which illustrates a side view of a marine-based survey 360 of a subterranean subsurface 362 in accordance with one or more implementations of various techniques described herein. Subsurface 362 includes seafloor surface 364. Seismic sources 366 may include marine sources such as vibroseis or airguns, which may propagate seismic waves 368 (e.g., energy signals) into the Earth over an extended period of time or at a nearly instantaneous energy provided by impulsive sources. The seismic waves may be propagated by marine sources as a frequency sweep signal. For example, marine sources of the vibroseis type may initially emit a seismic wave at a low frequency (e.g., 5 Hz) and increase the seismic wave to a high frequency (e.g., 80-90Hz) over time.

The component(s) of the seismic waves 368 may be reflected and converted by seafloor surface 364 (i.e., reflector), and seismic wave reflections 370 may be received by a plurality of seismic receivers 372. Seismic receivers 372 may be disposed on a plurality of streamers (i.e., streamer array 374). The seismic receivers 372 may generate electrical signals representative of the received seismic wave reflections 370. The electrical signals may be embedded with information regarding the subsurface 362 and captured as a record of seismic data.

In one implementation, each streamer may include streamer steering devices such as a bird, a deflector, a tail buoy and the like, which are not illustrated in this application. The streamer steering devices may be used to control the position of the streamers in accordance with the techniques described herein.

In one implementation, seismic wave reflections 370 may travel upward and reach the water/air interface at the water surface 376, a portion of reflections 370 may then reflect downward again (i.e., sea-surface ghost waves 378) and be received by the plurality of seismic receivers 372. The sea-surface ghost waves 378 may be referred to as surface multiples. The point on the water surface 376 at which the wave is reflected downward is generally referred to as the downward reflection point.

The electrical signals may be transmitted to a vessel 380 via transmission cables, wireless communication or the like. The vessel 380 may then transmit the electrical signals to a data processing center. Alternatively, the vessel 380 may include an onboard computer capable of processing the electrical signals (i.e., seismic data). Those skilled in the art having the benefit of this disclosure will appreciate that this illustration is highly idealized. For instance, surveys may be of formations deep beneath the surface. The formations may typically include multiple reflectors, some of which may include dipping events, and may generate multiple reflections (including wave conversion) for receipt by the seismic receivers 372. In one implementation, the seismic data may be processed to generate a seismic image of the subsurface 362.

Marine seismic acquisition systems tow each streamer in streamer array 374 at the same depth (e.g., 5-10m). However, marine based survey 360 may tow each streamer in streamer array 374 at different depths such that seismic data may be acquired and processed in a manner that avoids the effects of destructive interference due to sea-surface ghost waves. For instance, marine-based survey 360 of Figure 3B illustrates eight streamers towed by vessel 380 at eight different depths. The depth of each streamer may be controlled and maintained using the birds disposed on each streamer.

Artificial intelligence (AI) techniques may be used to develop machine learning (ML) based surrogate reservoir models. These models may learn from a massive amount of simulation data to unravel complex patterns between static and dynamic properties, and thus may replace a cumbersome simulation process with an intelligent and time efficient process. In some embodiments, a workflow for automated model calibration and simulation data forecasting using state-of-the-art AI techniques are disclosed. Thus, a time-consuming component in a workflow may be replaced with an intelligent ML agent which may be embedded in a holistic solution driven by optimization techniques.

In an embodiment, the workflow may be targeted for applications that include exploring a wide space of parameters with an objective of finding a best solution. The process may be cumbersome and time consuming, and may still permit uncertainty in the selection of parameters. In one embodiment, an ML proxy model may be built by utilizing deep learning for data forecasting to replace a time-consuming block in a workflow. The model may be trained from a massive amount of simulation data. This learning may be transferred to new, unseen data, thus acting as a prompt intelligence simulator. An ML surrogate model may be embedded as a black box within a fully integrated workflow to automate a history matching process. An AI solution may recommend model parameters with reduced time and computational cost.

More particularly, many applications require calibrating a set of parameters to generate a model that represents actual data. For example, the history matching process may involve exploring multiple sets of uncertainty parameters values to find the optimal solution. The procedure is time consuming and involves evaluating many realizations. For this reason, optimization workflows can be utilized to analyze the search space so that combination of uncertainty parameters may be identified rapidly. To evaluate the simulation results for each realization, an ML proxy model may be embedded in the workflow, after which the error between simulated and actual data is computed. In an embodiment, an ML surrogate model is utilized because running the simulator at each step is time consuming and costly. The solution which yields the least discrepancy between simulated and historical data may then be selected.

The developed proxy ML model may act as a black-box component where it can be used to promptly forecast the simulation results. It may perform like a simulator with immensely improved speed because of the prompt nature of ML predictions. After the optimal solution is identified using optimization, the simulation may be re-run using these parameters and the accuracy of the results may be validated.

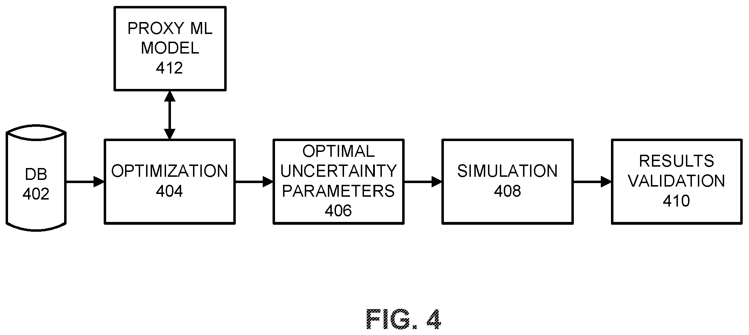

Figure 4 illustrates an embodiment of the workflow. According to Figure 4, a database 402 of static and dynamic data is input into optimization 404. Optimization 404 uses proxy ML model 412 having uncertainty parameters as inputs and timeseries data as output. As the term is used herein, "optimization" refers to the process of seeking parameters that suit a given application. It should not be considered to be limited to identifying the best possible parameter, but rather of executing a process that is designed to select parameters in an analytical fashion (which might or might not be the best parameters, depending on, for example, runtime, processing resources, problem description, etc.). Optimization 404 uses a proxy ML model 412 to determine uncertainty parameters 406. The uncertainty parameters 406 are provided to a simulator to produce a simulation 408 using the uncertainty parameters 406. Results of the simulation may be validated 410 by determining whether simulation results with the optimal uncertainty parameters are within an error tolerance of output of proxy machine learning model 412 using optimal uncertainty parameters 406.

Machine learning may be utilized to replace a simulator by predicting production data given a set of uncertainty parameters values. In one embodiment, the ML model may be an artificial neural network and/or a deep learning model, which tailors a timeseries nature of the data. In other embodiments, other ML models may be used.

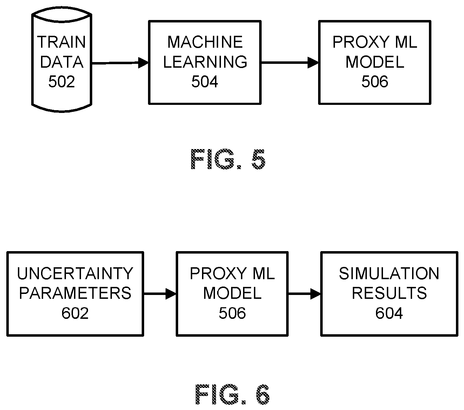

Figure 5 shows a workflow for training a proxy ML model, e.g., to predict an output of a simulation of a physics-based model. Machine learning 504 may input training data to produce a trained proxy ML model 506. The training data may have been produced by a simulator (e.g., a simulation of a physics-based model) based on historical data. The trained proxy ML model 506 may be capable of outputting both timeseries production and injection profiles for each well in a reservoir simulation model, and different properties (e.g., time dependent pressure, saturation properties of each grisd cell) of the reservoir simulation model.

The ML proxy model, as shown in Figure 6 may be used as a black box to reduce time and computations required by an actual simulator. According to the workflow of Figure 6, multiple sets of uncertainty parameters 602 are provided to trained proxy ML model 506 to produce simulation results 604, which actually are predictions based on the provided sets of uncertainty parameters. As previously described, the ML proxy model may be embedded in a larger workflow acting as a simulator. The solution may be employed for different types of data and may use a best deep learning approach depending on the data type.

Optimization workflow 404 may have seek to reduce a mismatch between actual production data and simulated production data. In other words, the optimization workflow 404 attempts to find a solution including a combination of uncertainty parameters that yield a low simulation error. The optimization workflow 404 may be a minimization optimization problem in which a solution with minimal error between actual and simulation data is sought. A tolerance may be specified, which may be an upper limit for acceptable discrepancies between the actual data and simulated data.

In some embodiments, bounds constraints may be defined for each uncertainty parameter in order to limit a solutions space to feasible solutions. A workflow may start with an initial guess for a set of uncertainty parameters, which may be specified or generated randomly. An initial solution may be compared with simulation results using a same set of uncertainty parameters and an error value associated with the ML proxy model results may be computed. If the error is within the tolerance specified, the solution converges and the process may stop. However, it is uncommon to find a suitable solution from a first iteration. If the area is above the specified tolerance, the workflow may explore a new solution while taking into consideration results from a previous solution.

The new solution depends on the workflow specified and how workflow employs exploration versus exploitation approaches, among potentially other factors. The new solution may then be evaluated and the value of the objective function for the solution may again be compared with the specified tolerance. If the solution is within the specified tolerance, the workflow may halt, and a current solution is flagged as an optimal solution. Otherwise, the workflow may recursively repeat previous steps until an error tolerance is within the specified tolerance or other constraints are met, such as: a time constraint, a maximum number of iterations constraint, etc.

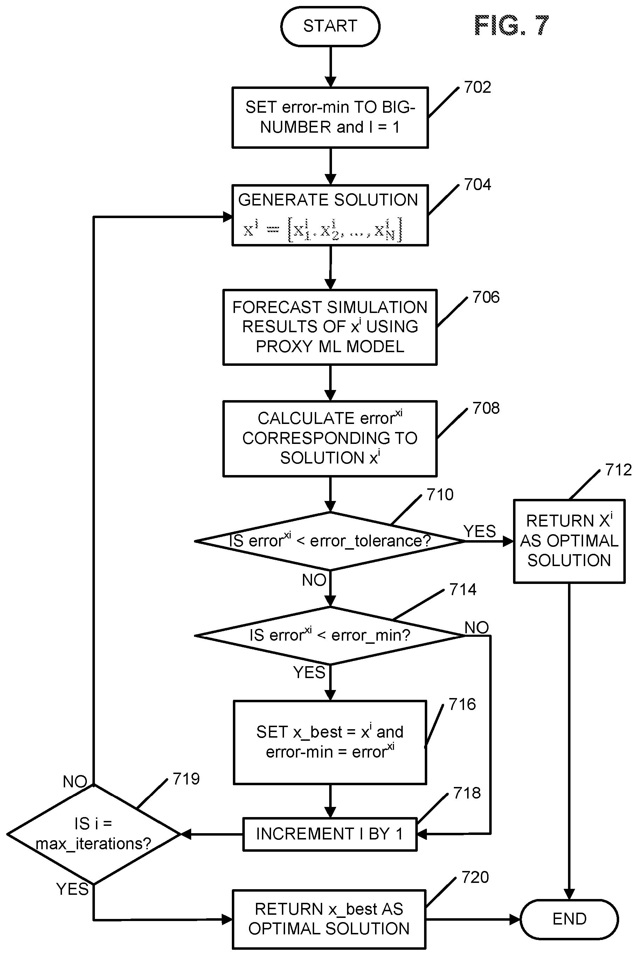

Figure 7 is a flowchart that illustrates an embodiment of the workflow of Figure 4 in more detail. The workflow may begin by setting error_min to a number that is larger than a possible difference between a proxy ML model output and a corresponding simulator output, and by setting an iteration counter, I, to 1 (act 702). Next, a solution, which is a set of uncertainty parameter values xⁱ, may be generated (act 704). Using the proxy ML model, simulation results of xⁱ may be forecast (act 706). An error, error^{xi}, corresponding to solution xⁱ may be calculated (act 708). Error^{xi} may be based on a difference between the forecasted simulation results using the proxy ML model and the corresponding simulation results.

Next, a determination is made regarding whether error^{xi} is less than a desired error tolerance (act 710). If so, then the workflow is halted and xⁱ is returned as an optimal solution (act 712).

If, during act 710 error^{xi} is determined not to be less than the desired error tolerance then a determination is made regarding whether error^{xi} is less than error_min (act 714). At this point, error_min is either equal to a large number or a previous value of error^{xi}. If error^{xi} is determined to be less than error_min then x_best is set to xⁱ and error^{xi} is saved to error_min (act 716).

After performing act 716 or after determining that error^{xi} is not less than error_min, iteration counter, i, may be incremented by one (act 718).

Next, a determination is made regarding whether iteration counter, i, is equal to a maximum number of iterations (act 719). If i is not equal to the maximum number of iterations, then act 704 may be performed to generate a next solution of uncertainty parameters (act 704). Otherwise, if i is equal to the maximum number of iterations, then the solution saved at x_best may be returned as an optimal solution.

The workflow shown in Figure 7 is one example of a workflow, many other different workflows may be used in other embodiments.

In some embodiments, tools and supported workflow steps may be clearly separated based on capability to achieve a maximum degree of performance scalability. Further, (1) geomodeling and simulation tools may be used for generating model output data; (2) based on decision objectives, multi-objective model responses may be extracted and/or calculated from model output data (time or depth dependent, spatial, etc.); (3) analytics may be applied to processed response data for automatic interpretation and result analysis; and (4) automatic predictive modeling may be used to generate history matching candidates.

Multi-objective response values included in analytics and ML workflows may correlate with a definition of a calibrated model. Automatic data selection and processing mechanisms may be used to extract a few representative data points from model output data for data analysis.
In some embodiments, the processing described with respect to Figure 7 may be performed in a cloud using, for example, agile reservoir modeling (ARM) such that thousands of simulations with different uncertainty parameter values may be executed simultaneously. The optimal set of results (e.g., reservoir models matching historical actual reservoir performance) obtained using the above-described method can be fed in Model Selection System and/or Well Placement Selection Under Uncertainty methods.

### Model Selection System

One of more of the calibrated models may be employed in an uncertainty analysis, e.g., to produce and evaluate multiple different model realizations. Uncertainty is prevalent in reservoir characterization studies. In order to make business decisions, companies may execute studies where a model is built to describe the behavior of the reservoir. Impacting parameters are identified, along with their probability distributions. These impacting parameters may be reservoir parameters (e.g., porosity, permeability, structure, rock quality), economical (e.g., oil price), combinations thereof, or otherwise. These parameters may be derived from raw, measured data.

A set of these parameters define a probable model, also referred to as a model "realization", e.g., models of a same subsurface volume (e.g., reservoir) but with different parameters based on probability and matching the actual historical production data. A given realization can then go through one or more numerical experiments, after which outputs are obtained (also referred to as "responses"). These may be referred to as performance key performance indicators (KPIs) which are directly or indirectly related to decision making criteria. Examples of KPIs include ultimate recovery, volumes in place, , potential production and injection rates and economic metrics (e.g., net present value).

It is understood that sampling the distribution of the input parameters that are matching historical actual production data can lead to a large number of realizations, which are equiprobable. Given realistic constraints on processing capabilities, even leveraging "cloud" computing resources, it is impractical to perform and analyze so many numerical experiments. Thus, the impact of a given parameter on the responses may be incorrectly estimated due to the difficulty in exploring the existing uncertainty variables in later stages of the study. Users thus may choose a deterministic approach, and/or may be scenarios chosen manually, without a systematic consideration of the responses that impact decision making.

The combination of different analysis and methodologies can allow one to reduce the number of models needed to be assessed to still obtain accurate responses. This enables the study to explore many more scenarios and possibilities, enriching the decision-making process.

In an embodiment, an application that can read from a database of different observations (e.g. model realizations of a particular reservoir along with their inputs - such as porosity, permeability, rock types, and responses - such as timeseries production and injection profiles for all wells, in-place volume, recovery), and, based on data analysis via a conjunction of visualizations, machine learning and artificial intelligence methods, automatically selects a classified subset of representative observations containing, in some embodiments, the least amount necessary to properly characterize the behavior (e.g., cumulative distribution function) of one or more selected meaningful responses. Furthermore, the application enables the user to enter input parameters pertaining to a specific reservoir realization and obtain a prediction of the behavior of the trained responses.

Current workflows focus on the overall integrated workflow, and not specifically on the model selection. Therefore, although some workflows may present functionality that allows for a manual, guided selection practice, there is a need, under a single system, for a unified workflow that provides: sensitivity on the impact of input variables in the response parameters, allowing identification of most meaningful variables and elimination of those which are not; understanding and quantifying relationships between inputs, with the possibility to reduce the number of studied variables by implementing cross-relationship functions; further reduction of parameters by usage of dimensionality reduction methods, thus allowing the incorporation of multiple responses into the model selection; definition of the number of models necessary to have in order to model the responses within a certain variance margin; automated selection of a set of models which would accurately represent the distribution of the responses; and/or (6) a possibility to estimate the behavior of a new realization previously not included in initial ensemble.

Furthermore, there is possibility to enhance this through link of external systems: (1) linking the input to Schlumberger products, such as, Petrel, DELFI, Agile Iterative Reservoir Modelling or other tools that enable the creation of a large number of static and/or dynamic reservoir models; and/or (2) connecting the output to Schlumberger products DELFI, RE Workspace, FDPlan, other bespoke tools that would use an ensemble of models for uncertainty, optimization, analysis, decision making.

This is achievable through a combination of data science and artificial intelligence including: (1) innovative visualization techniques incorporated in a decision dashboard; and/or (2) statistical, machine learning and other data science methods which may include dimensionality reduction, clustering, regression using neural networks, decision trees methods etc.

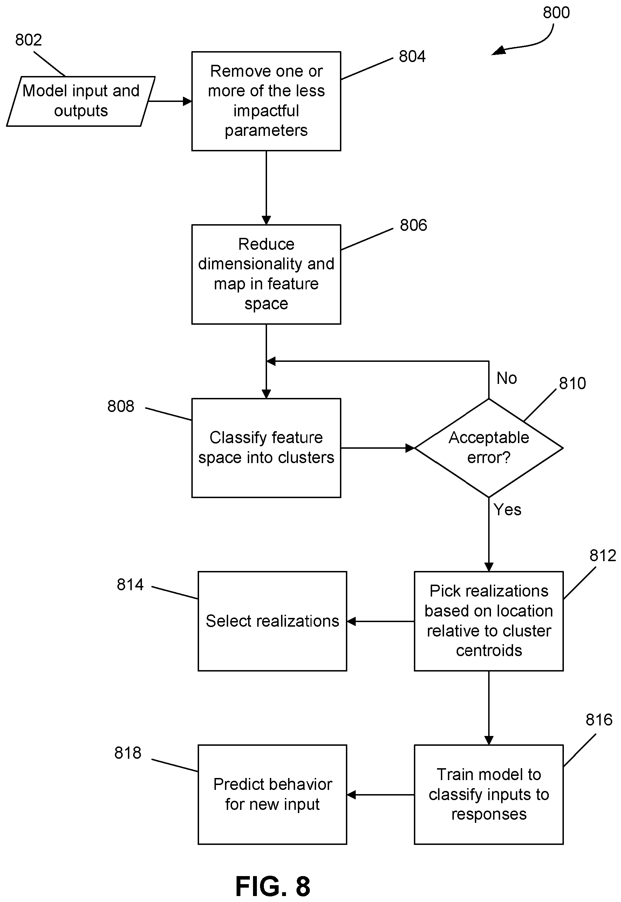

Figure 8 illustrates a flowchart of a method 800 for selecting a classified subset of representative observations, according to an embodiment. The method 800 may, for example, be configured to constrain the number of observations selected so as to a least (or at least close to the least) number of observations to accurately characterize behavior (e.g., generate a cumulative distribution function) of one or more selected, "meaningful" responses.

The method 800 may include receiving, as input, model inputs and outputs, as at 802. The inputs may include, as noted above, rock properties, fluid properties, reservoir properties, etc. The outputs may include one or more KPIs, as also discussed above.

The method 800 may include removing one or more of the less impactful parameters, as at 804. Such lesser impactful parameters may be determined based on a statistical analysis of the impact that a change in the parameters has on the response. The method 800 may also include reducing the dimensionality to accommodate multiple responses, as at 806. The remaining, vectorized realizations may then be mapped in feature space.

The method 800 may also leverage artificial intelligence, such as, for example, using unsupervised, clustering-based machine learning. For example, the method 800 may include classifying the elements (realizations) mapped in the features pace into clusters, as at 808.

The method 800 may then include determining whether an acceptable error is experienced, as at 810. This may be statistically determined, for example, based on the success of the clustering applied. If the error is not acceptable, the method 800 may return to classifying into clusters and employ different techniques and/or parameters for such clustering.

The method 800 may then proceed to picking realizations based on location relative to cluster centroids, as at 812. For example, one or more realizations that are closest to the centroids may be selected as representative of the cluster, and these realizations may be selected, as at 814, for further uncertainty analysis, e.g., using physical model simulations.

Additionally, the selected and/or other realizations may be employed to train a machine learning model to classify inputs to responses, that is, to predict responses based on a set of inputs, as at 816. For example, results of collection of simulation cases, e.g., in the form of measured inputs and outputs may be fed to the model as training data. Further, simulated outputs from inputs, e.g., in given realizations, may be fed to the model, and thus the model may be trained to predict what response/output would be produced, given a set of model input parameters, as at 818.

By executing the method 800, users may generate a reduced ensemble of realizations and incorporate them into previously prohibitive uncertainty and other types of modelling studies such as field development planning, production and injection forecasting, well placement, history matching, etc. The results (e.g., selected representative reservoir models) can be fed into Well Placement Selection Under Uncertainty method.

### Reservoir Quality Maps/Assessment

Reservoir performance is modeled for future field development planning purposes. Areas with low performance can be investigated for production enhancement, areas without wells can be investigated for infill drilling. However, reaching this understanding includes integrating data from various sources to obtain the best insight.

Reservoir quality maps may be built from reservoir properties such as permeability, net-to-gross ratio, porosity, hydrocarbon volumes in place, and these can take various names such as maps of reservoir quality index, simulation opportunity index, reservoir opportunity index etc. The maps are derived from reservoir models subject to uncertainty and simulation studies to identify potential areas for infill drilling.

In an embodiment, a reservoir quality map using reservoir characteristics and hydrocarbon volumes in place, and also historical well performance by analyzing the historical production and injection data of some and/or all wells in the field, their associated log data and core data, and/or possibly information from the reservoir model to build a machine learning model capable of establishing a map of reservoir quality and production performance. The generated map may be used to analyze the performance of existing wells for production enhancement, identify areas for infill drilling, and/or identify areas for additional measurements to improve the understanding of the reservoir through not only the reservoir modeling aspect.

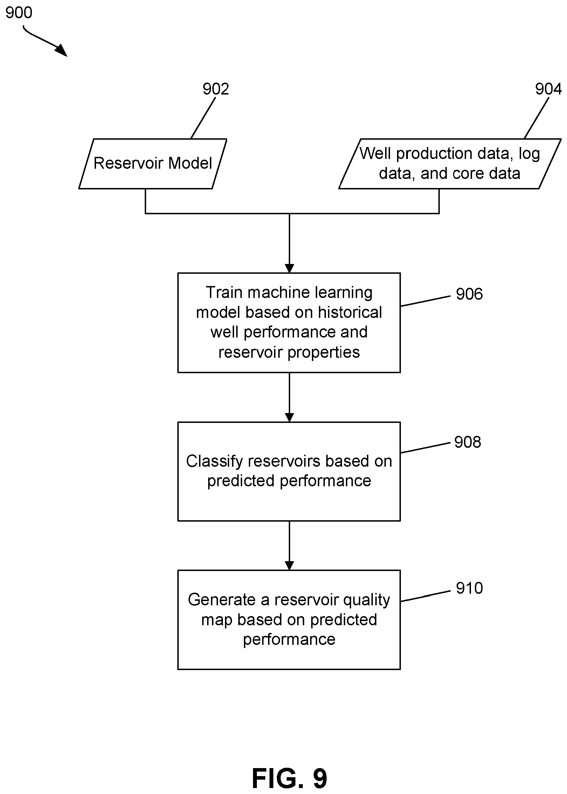

As mentioned above, machine learning techniques may be employed, e.g., for model realization selection in the context of uncertainty analysis and elsewhere. Figure 9 illustrates an example of one type of machine learning method that may be used, showing a flowchart of a method 900 for building a machine learning model to generate reservoir quality map. The method 900 may receive, as input, a reservoir model representing a subsurface volume or other rock properties, as at 902. The method 900 may also receive, as input, reservoir data, also representing the subsurface volume or rock properties, as at 904, such as well measurement data, such as production and injection history (e.g. rates, volumes produced, pressures), well location (e.g. distance to injectors, distance to other production wells), log data and core data providing insights on reservoir properties (e.g. permeability, porosity, saturation, pressure), and/or reservoir properties derived from the reservoir model when measured data is lacking.

The machine learning model may be trained, as at 906, to create a map of reservoir quality based on the information from well performance and reservoir quality. The quality of the remaining of the reservoir can be evaluated using the machine learning based on the reservoir properties based on the predicted performance.

The method 900 may thus include implementing such a trained model, as at 908, e.g., to classify reservoirs based on predicted performance. Outlier wells may be identified and may potentially be wells requiring production enhancement, areas without wells and flagged with good performance can be targeted for infill drilling where data acquisition can be performed to confirm the model prediction and improve the reliability of the machine learning model. Because machine learning methods integrating both reservoir properties and historical well performance may be used, thus enabling integration of the well performance in the identification of reservoir quality. This allows for the identification of poor well performers as candidate for production enhancement, perform well placement location optimization, and/or identify areas requiring further data acquisition. Accordingly, the method 900 may also include generating a reservoir quality map based on the predicted performance, as at 910. This method can be used as an alternative method of selecting "hot spots" in Well Placement Selection Under Uncertainty method.

### Well Placement Selection Under Uncertainty

Production in an oil field can be increased by improving the performance of existing wells or by drilling additional wells. The performance of the new wells drilled may depend on the location in the reservoir where they are drilled; that is, even in a given reservoir, certain well placements, trajectories, and other parameters may yield better production performance than others.

To locate the potential areas within the reservoir to drill such new wells, engineers may rely on reservoir simulation models to identify the areas where the most oil volume remains with favorable pressure and reservoir rock quality to facilitate hydrocarbon extraction. Reservoir simulation model quality and the quality of the model calibration, if applicable, may play impact the accuracy of such identification. Additionally, to identify which areas identified would lead to favorable production performance, multiple simulation scenarios are generally evaluated to determine the potential performance for each individual area.

Probability maps may be built, which include identified "hot spots" in the reservoir through a probabilistic approach. Such probabilistic approaches may proceed by simulation of physics models, e.g., without assistance from artificial intelligence or production data analysis. By evaluating the potential areas for well placement by analyzing the historical production data of all wells in the field, the associated log data and core data, and/or, in some embodiments, information from the reservoir model to build a machine learning model configured to classify the hot spots, e.g., as discussed above, into reservoir properties leading to gradations of production potential (e.g., numerical scales, qualitative "good", "poor", "medium " scores, etc.). The baseline for such potential grades may be historical wells, comparison to which may be used for ranking and selection of candidate wells.

Classifying the hotspots based on actual, historical performance data associated with the identification of potential areas ("hot spots") within the reservoir to drill new wells can improve the confidence of the area selection, reduce the time taken to evaluate which areas have a better potential for production since each area would not need to be tested beforehand through reservoir simulation, and/or enable better decision making in field development planning.

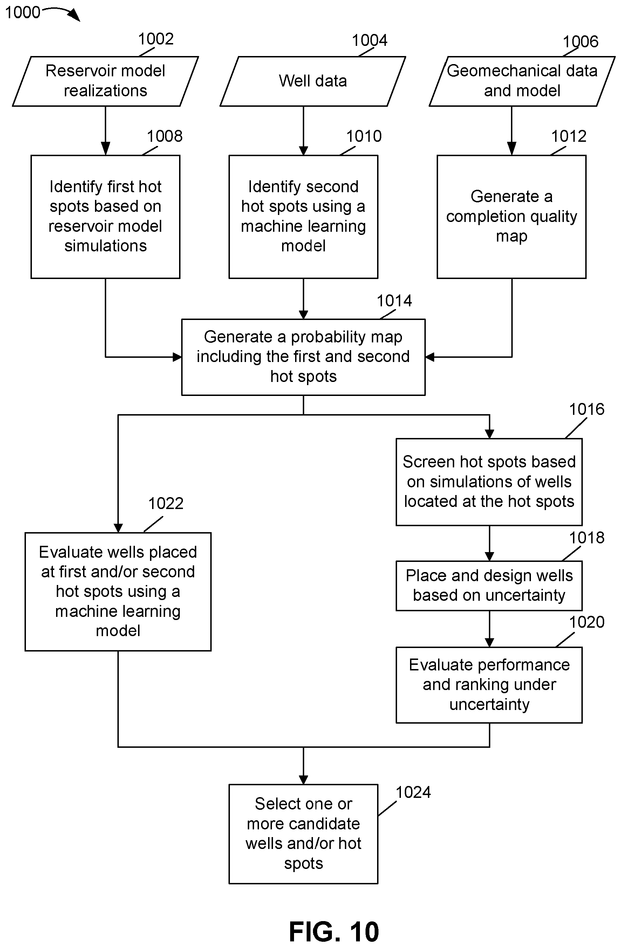

Turning to the illustrated embodiments, Figure 10 illustrates a flowchart of a method 1000 for drilling a well, e.g., based on a selection of a location for the well, according to an embodiment. The method 1000 may receive, as input, an ensemble of reservoir model realizations, as at 1002. As discussed above, the realizations may be a representative subset of the model realizations that are available based on an uncertainty analysis, with, for example, the representative subset being selected using a machine learning model. Further, the method 1000 may receive well data as input, at 1004. The well data may be measured characteristics of the well, including production history, log data, core data, and/or any other data. In at least one embodiment, the method 1000 may also include receiving geomechanical data (e.g., stress, strain, Poisson's ratio, etc.) for the subsurface, which may be presented, e.g., as a geomechanical model, as at 1006.

From the ensemble of simulations generated through uncertainty analysis, an opportunity index may be calculated based on reservoir properties (e.g. rock properties, fluid saturations, pressure) for each realization. A probability that the opportunity is above a given threshold may be calculated considering the ensemble of opportunity index generated, and/or the areas of higher probability are considered as "hot spots" for drilling. These areas are potentially good quality rock with good hydrocarbon reserves remaining. Accordingly, the method 1000 may include identifying these as one or more "first" hot spots, again, based on the physical reservoir model simulations, as at 1008.

The well data may be employed to identify one or more "second" hot spots, as at 1010. A machine learning model may be built to link well measurement data such as production and injection history (e.g., rates, volumes produced, pressures), well location (e.g. distance to injectors, distance to other production wells), log data and/or core data providing insights on reservoir properties (e.g. permeability, porosity, saturation, pressure), and/or reservoir properties derived from the reservoir model when measured data is lacking. The machine learning model may derive a relationship between reservoir properties/quality and production performance. The first and second hot spots may not be mutually exclusive, but may, in at least some embodiments be overlapping or the same. For example, at least some of the first hot spots may identify the same locations as at least some of the second hot spots. In other embodiments, the first and second hot spots may not refer to any of the same locations.

Additionally, a completion quality map may be generated, as at 1012, using a mechanical earth model to assess the quality of completions (e.g., conventional completions, hydraulic fractures, etc.). Accordingly, the completion quality may be employed to further strengthen the identification of hot spots and/or to identify separate hot spots.

Resulting hot spots identified from the reservoir simulations, the machine learning, and/or the geomechanical model may be employed to generate a probability map, as at 1014. The probability map may be two or three dimensional and may represent at least a portion of the subsurface volume. The probability map may be visualized, e.g., including different colors or other identifications of the hot spots to facilitate reference thereto by one or more operators.

The first and/or second hot spots may then be evaluated. In particular, as at 1016, hypothetical "candidate wells" may be located at the hot spots and then the reservoir. Further, well trajectory design techniques may be implemented to design suitable wells at the hot spots, as at 1018. The reservoir may then be simulated with the candidate wells located at one or more of the hot spots, as at 1020. The simulation may provide a forecast of production (e.g., performance) of the candidate wells at the hot spots, and the candidate wells may then be ranked or otherwise ordered, e.g., based on production, drilling risk, expense, rate of return, etc.

In some embodiments, another machine learning model may be implemented, e.g., instead of or in addition to the simulation at 1016. For example, as at 1022, well placement location can be selected through a machine learning model trained to link well and reservoir parameters to production performance. As discussed above, such machine learning models may be trained using historical performance data, modeled/simulated data, or a combination thereof. An example of such a machine learning implementation is provided below.

Additionally, injection well placement can be incorporated at a varying distance from the production wells to identify candidate injection wells and their configurations that will contribute to enhance production further.

Further, in at least some embodiments, both simulating and machine-learning prediction may be employed to forecast well production. Machine-learning well production forecast can rapidly screen all identified hotspots and eliminate poor areas from further iterations using the reservoir simulation. Integrating multiple techniques/sources of production forecasting may improve the reliability of the well placement location selection and accelerate the screening process by integrating multiple data sources (e.g., reservoir simulation model, historical well performance, geomechanical considerations, drilling risks) in the selection process. The method 1000 may then proceed to selecting one or more of the candidate wells at the identified first and/or second hot spots, as at 1024. In some embodiments, visualizations of digital models of the subsurface, e.g., including the hot spots and the selected candidate wells, may be displayed for a user. The user may interact with the display, e.g., to glean additional information about the candidate well and/or hot spot. Further, the user may employ the generated visualization for drilling activities. In at least one embodiment, a user may construct the selected candidate well based at least in part on the visualization or otherwise based on the selected candidate well.

### Well Performance Forecasts

As noted above, a machine learning model can be used to forecast well performance. Field development planning includes well performance forecasting to assess the future performance of a well and select a development scenario. In an embodiment a methodology using machine learning methods may be used to: (1) predict future performance of an existing producing well; and/or (2) predict performance of an undrilled well at a new location. More particularly, in an embodiment, a well performance forecast may be based on historical well performance data (oil, gas, water production and injection rates and cumulative volumes; bottomhole, tubing head and reservoir pressure) combined with geological properties of the reservoir (e.g. permeability, porosity, saturation, pressure), well location (e.g., distance to producers and injectors), well log and/or core data (e.g., permeability, porosity, saturation, pressure) for conventional reservoirs that may be under primary or secondary recovery processes (e.g. waterflooding).

Through this methodology, future well performance may be predicted without relying on analytical methods, decline curve analysis or numerical methods such as reservoir simulation. The methodology may produce faster results to perform short-term production forecasts, operationalize insights, provide another perspective on performance prediction and/or decision making in the context of field development planning. Advanced machine learning methods (deep learning methods) may integrate different types of data such as time series (oil, gas, water production and injection rates and cumulative volumes; bottomhole, tubing head and reservoir pressure) and tabular data (e.g., geological, petrophysical as described earlier) to predict future performance of existing as well as new wells.

In an embodiment, the workflow may be used to predict future performance of existing wells. The model may continuously learn from continuously updating production data and generate future production profiles for each well in the field using reinforcement learning methods. This will facilitate decision-making process targeted at field development planning such as whether there is a need to drill a new well to meet production target etc.

In an embodiment, the workflow may be used to predict future performance of a new well in the field. The model may continuously learn from continuously updating production data as well as geological data and generate future production profiles for a new well in the field. Fast screening of performance of new wells at different locations will allow to optimize well placement process. This methodology may be integrated with the "Well Placement Selection Under Uncertainty" method discussed above to test out different hotspots generated using probabilistic methods and rank them based on the performance of new wells.

The workflow may be able to produce accurate real-time production forecast for existing wells and production prediction faster and able to screen thousands of locations to generate the most optimal location to drill a well.

In other words, well performance forecast of existing wells may be used to generate "live and evergreen model" that continuously updates and provides up to date well forecasts based on historical data. This data then can then be used to optimize field development planning. Furthermore, well performance forecast of a new well may be used to generate rapid results that allows to screen thousands of well locations to select the most optimal one - complimenting or replacing current technologies used for the same purposes.

### Computing Environment

In one or more embodiments, the functions described can be implemented in hardware, software, firmware, or any combination thereof. For a software implementation, the techniques described herein can be implemented with modules (e.g., procedures, functions, subprograms, programs, routines, subroutines, modules, software packages, classes, and so on) that perform the functions described herein. A module can be coupled to another module or a hardware circuit by passing and/or receiving information, data, arguments, parameters, or memory contents. Information, arguments, parameters, data, or the like can be passed, forwarded, or transmitted using any suitable means including memory sharing, message passing, token passing, network transmission, and the like. The software codes can be stored in memory units and executed by processors. The memory unit can be implemented within the processor or external to the processor, in which case it can be communicatively coupled to the processor via various means as is known in the art.

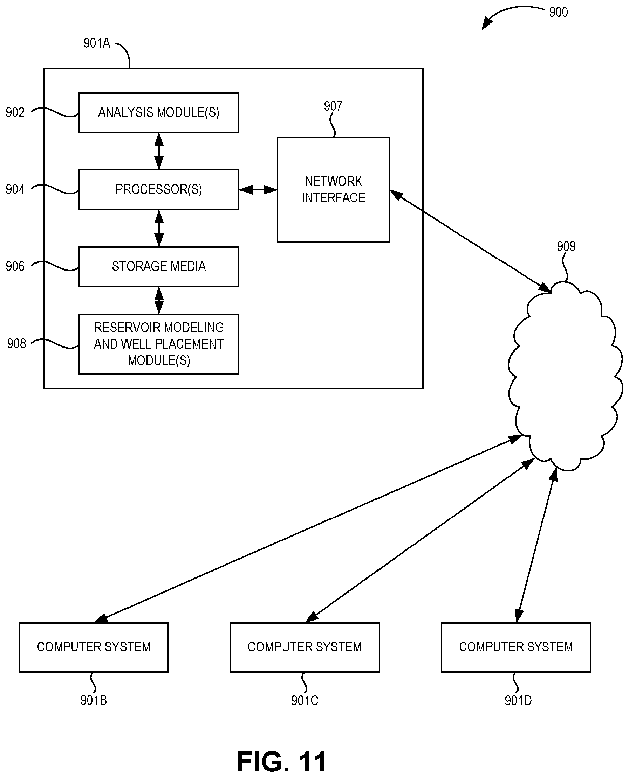

In some embodiments, any of the methods of the present disclosure may be executed by a computing system. Figure 11 illustrates an example of such a computing system 1100, in accordance with some embodiments. The computing system 1100 may include a computer or computer system 1101A, which may be an individual computer system 1101A or an arrangement of distributed computer systems. The computer system 1101A includes one or more analysis module(s) 1102 configured to perform various tasks according to some embodiments, such as one or more methods disclosed herein. To perform these various tasks, the analysis module 1102 executes independently, or in coordination with, one or more processors 1104, which is (or are) connected to one or more storage media 1106. The processor(s) 1104 is (or are) also connected to a network interface 1107 to allow the computer system 1101A to communicate over a data network 1109 with one or more additional computer systems and/or computing systems, such as 1101B, 1101C, and/or 1101D (note that computer systems 1101B, 1101C and/or 1101D may or may not share the same architecture as computer system 1101A, and may be located in different physical locations, e.g., computer systems 1101A and 1101B may be located in a processing facility, while in communication with one or more computer systems such as 1101C and/or 1101D that are located in one or more data centers, and/or located in varying countries on different continents).

A processor can include a microprocessor, microcontroller, processor module or subsystem, programmable integrated circuit, programmable gate array, or another control or computing device.

The storage media 1106 can be implemented as one or more computer-readable or machine-readable storage media. Note that while in the example embodiment of Figure 11 storage media 1106 is depicted as within computer system 1101A, in some embodiments, storage media 1106 may be distributed within and/or across multiple internal and/or external enclosures of computing system 1101A and/or additional computing systems. Storage media 1106 may include one or more different forms of memory including semiconductor memory devices such as dynamic or static random access memories (DRAMs or SRAMs), erasable and programmable read-only memories (EPROMs), electrically erasable and programmable read-only memories (EEPROMs) and flash memories, magnetic disks such as fixed, floppy and removable disks, other magnetic media including tape, optical media such as compact disks (CDs) or digital video disks (DVDs), BLURAY^{®} disks, or other types of optical storage, or other types of storage devices. Note that the instructions discussed above can be provided on one computer-readable or machine-readable storage medium, or alternatively, can be provided on multiple computer-readable or machine-readable storage media distributed in a large system having possibly plural nodes. Such computer-readable or machine-readable storage medium or media is (are) considered to be part of an article (or article of manufacture). An article or article of manufacture can refer to any manufactured single component or multiple components. The storage medium or media can be located either in the machine running the machine-readable instructions, or located at a remote site from which machine-readable instructions can be downloaded over a network for execution.

In some embodiments, computing system 1100 contains one or more reservoir modeling and well placement module(s) 1108. In the example of computing system 1100, computer system 1101A includes the reservoir modeling and well placement module 1108. In some embodiments, a single reservoir modeling and well placement module may be used to perform some or all aspects of one or more embodiments of the methods. In alternate embodiments, a plurality of reservoir modeling and well placement modules may be used to perform some or all aspects of methods.

It should be appreciated that computing system 1100 is only one example of a computing system, and that computing system 1100 may have more or fewer components than shown, may combine additional components not depicted in the example embodiment of Figure 11, and/or computing system 1100 may have a different configuration or arrangement of the components depicted in Figure 11. The various components shown in Figure 11 may be implemented in hardware, software, or a combination of both hardware and software, including one or more signal processing and/or application specific integrated circuits.

Further, the steps in the processing methods described herein may be implemented by running one or more functional modules in information processing apparatus such as general purpose processors or application specific chips, such as ASICs, FPGAs, PLDs, or other appropriate devices. These modules, combinations of these modules, and/or their combination with general hardware are all included within the scope of protection of the invention.

Geologic interpretations, models and/or other interpretation aids may be refined in an iterative fashion; this concept is applicable to embodiments of the present methods discussed herein. This can include use of feedback loops executed on an algorithmic basis, such as at a computing device (e.g., computing system 1100, Figure 11), and/or through manual control by a user who may make determinations regarding whether a given step, action, template, model, or set of curves has become sufficiently accurate for the evaluation of the subsurface three-dimensional geologic formation under consideration.

The foregoing description, for purpose of explanation, has been described with reference to specific embodiments. However, the illustrative discussions above are not intended to be exhaustive or to limit the invention to the precise forms disclosed. Many modifications and variations are possible in view of the above teachings. The embodiments were chosen and described in order to explain the principles of the invention and its practical applications, to thereby enable others skilled in the art to utilize the invention and various embodiments with various modifications as are suited to the particular use contemplated.

## Claims

1. A computer-implemented method, comprising:
receiving data representing one or more reservoir properties for a subsurface volume;
conducting (1002) a probabilistic uncertainty analysis by simulating a plurality of different model realizations representing the subsurface volume;
identifying (1008) a first hot spot of the subsurface volume based at least in part on the uncertainty analysis, the first hot spot representing an area having a high predicted production performance, relative to other areas of the subsurface volume, based on the simulating of the different model realizations representing the subsurface volume;
identifying (1010) a second hot spot of the subsurface volume using a proxy machine learning model that is trained to predict well production performance of both existing and new wells based on historical well production performance data and reservoir properties and without simulating a physics-based model of the subsurface volume, wherein training the proxy machine learning model comprises:
mapping historical well production performance in a vector space based on one or more parameters selected from the group consisting of production and injection history, well location, log data, core data, and reservoir properties; and
identifying one or more clusters in the vector space; and
determining a relationship between the one or more parameters and the historical well performance based on the identified one or more clusters;
evaluating (1022) the first and second hot spots for well placement based at least in part on the predicted well production performance at the first and second hot spots, respectively; and
selecting (1024) at least one of the first hot spot or the second hot spot for well construction.

2. The method of claim 1, further comprising generating (1014) a probability map of the subsurface domain including representations of the first hot spot and the second hot spot.

3. The method of claim 2, further comprising:
receiving (1006) geomechanical data for the subterranean domain; and
determining (1012) a completion quality for at least a portion of the subsurface volume based at least in part on the geomechanical data,
wherein generating (1014) the probability map comprises generating the probability map based at least in part on the completion quality.

4. The method of claim 1, wherein evaluating the first and second hot spots comprises:
determining a production performance of a well located at the first hot spot and a production performance of a well located at the second hot spot, an injection performance of a well located at the second hot spot, or both, using a machine learning model that is trained to predict well performance from measured reservoir properties.

5. The method of claim 1, further comprising:
receiving (902, 904) historical well production performance data and reservoir properties.

6. The method of claim 1, wherein the probability map includes a plurality of first hot spots and a plurality of second hot spots, at least some of the first hot spots being the same as at least some of the second hot spots.

7. The method of claim 5, further comprising:
forecasting a performance of wells located at the first hot spots, the second hot spots, or both; and
ranking the first hot spots, the second hot spots, or both based on the forecasted performance.

8. The method of claim 1, further comprising visualizing a digital model of the subsurface volume including a visual representing of the probability map, the well at the selected location, or both.

9. The method of claim **1,** further comprising selecting one or more model realizations for conducting the uncertainty analysis, wherein selecting the one or more model realizations comprises:
receiving model inputs and model outputs;
determining model outputs for a plurality of model realizations based on the inputs;
clustering the model outputs based on the model inputs;
identifying clusters in the model outputs; and
selecting one or more representative model realizations from the individual clusters.

10. A computing system (901), comprising:
one or more processors (904); and
a memory system (906) comprising one or more non-transitory, computer-readable media storing instructions that, when executed by at least one of the one or more processors (904), cause the computing system (901) to perform operations, the operations comprising the steps of the method of any preceding claim.

11. A non-transitory, computer-readable medium (906) storing instructions that, when executed by at least one processor (904) of a computing system (901), cause the computing system (901) to perform operations, the operations comprising the method of any one of claims 1 to 9.

12. A computer program comprising instructions for implementing the method of any one of claims 1 to 9.

## Patentansprüche

1. Computerimplementiertes Verfahren, umfassend:
Empfangen von Daten, die eine oder mehrere Lagerstätteneigenschaften für ein unterirdisches Volumen darstellen;
Durchführen (1002) einer probabilistischen Unsicherheitsanalyse durch Simulieren einer Vielzahl von unterschiedlichen Modellrealisierungen, die das unterirdische Volumen darstellen;
Identifizieren (1008) eines ersten Hot Spots des unterirdischen Volumens basierend mindestens teilweise auf der Unsicherheitsanalyse, wobei der erste Hot Spot ein Gebiet, das eine hohe vorhergesagte Produktionsleistung, relativ zu anderen Gebieten des unterirdischen Volumens aufweist, darstellt, basierend auf dem Simulieren der unterschiedlichen Modellrealisierungen, die das unterirdische Volumen darstellen;
Identifizieren (1010) eines zweiten Hot Spots des unterirdischen Volumens unter Verwendung eines Proxy-Maschinenlernmodells, das darauf trainiert ist, um Bohrlochproduktionsleistung sowohl bestehender als auch neuer Bohrlöcher basierend auf historischen Bohrlochproduktionsleistungsdaten und Lagerstätteneigenschaften und ohne Simulieren eines physikbasierten Modells des unterirdischen Volumens vorherzusagen, wobei ein Trainieren des Proxy-Maschinenlernmodells umfasst:
Zuordnen historischer Bohrlochproduktionsleistung in einem Vektorraum basierend auf einem oder mehreren Parametern, die aus der Gruppe ausgewählt sind, bestehend aus Produktions- und Injektionshistorie, Bohrlochstandort, Log-Daten, Kerndaten und Lagerstätteneigenschaften; und
Identifizieren eines oder mehrerer Cluster in dem Vektorraum; und
Bestimmen einer Beziehung zwischen dem einen oder den mehreren Parametern und der historischen Bohrlochleistung basierend auf dem identifizierten einen oder den identifizierten mehreren Clustern;
Auswerten (1022) des ersten und des zweiten Hot Spots für Bohrlochplatzierung basierend mindestens teilweise auf der vorhergesagten Bohrlochproduktionsleistung an dem ersten beziehungsweise dem zweiten Hot Spot; und
Auswählen (1024) mindestens eines von dem ersten Hot Spot oder dem zweiten Hot Spot für Bohrlochkonstruktion.

2. Verfahren nach Anspruch 1, ferner umfassend ein Erzeugen (1014) einer Wahrscheinlichkeitskarte des unterirdischen Bereichs, einschließlich Darstellungen des ersten Hot Spots und des zweiten Hot Spots.

3. Verfahren nach Anspruch 2, ferner umfassend:
Empfangen (1006) geomechanischer Daten für den Untergrundbereich;
und
Bestimmen (1012) einer Komplettierungsqualität für mindestens einen Teil des unterirdischen Volumens basierend mindestens teilweise auf den geomechanischen Daten,
wobei das Erzeugen (1014) der Wahrscheinlichkeitskarte das Erzeugen der Wahrscheinlichkeitskarte mindestens teilweise basierend auf der Komplettierungsqualität umfasst.

4. Verfahren nach Anspruch 1, wobei das Auswerten des ersten und des zweiten Hot Spots umfasst:
Bestimmen einer Produktionsleistung eines Bohrlochs, das sich an dem ersten Hot Spot befindet, und einer Produktionsleistung eines Bohrlochs, das sich an dem zweiten Hot Spot befindet, einer Injektionsleistung eines Bohrlochs, das sich an dem zweiten Hot Spot befindet oder beides unter Verwendung eines Maschinenlernenmodells, das darauf trainiert ist, um Bohrlochleistung aus gemessenen Lagerstätteneigenschaften vorherzusagen.

5. Verfahren nach Anspruch 1, ferner umfassend:
Empfangen (902, 904) historischer Bohrlochproduktionsleistungsdaten und von Lagerstätteneigenschaften.

6. Verfahren nach Anspruch 1, wobei die Wahrscheinlichkeitskarte eine Vielzahl von ersten Hot Spots und eine Vielzahl von zweiten Hot Spots einschließt, wobei mindestens einige der ersten Hot Spots dieselben wie mindestens einige der zweiten Hot Spots sind.

7. Verfahren nach Anspruch 5, ferner umfassend:
Prognostizieren einer Leistung von Bohrlöchern, die sich an den ersten Hot Spots, den zweiten Hot Spots oder beiden befinden; und
Einstufen der ersten Hot Spots, der zweiten Hot Spots oder beider basierend auf der prognostizierten Leistung.

8. Verfahren nach Anspruch 1, ferner umfassend ein Visualisieren eines digitalen Modells des unterirdischen Volumens, einschließlich einer visuellen Darstellung der Wahrscheinlichkeitskarte, des Bohrlochs an dem ausgewählten Standort oder beides.

9. Verfahren nach Anspruch 1, ferner umfassend das Auswählen einer oder mehrerer Modellrealisierungen zum Durchführen der Unsicherheitsanalyse, wobei das Auswählen der einen oder der mehreren Modellrealisierungen umfasst:
Empfangen von Modelleingaben und Modellausgaben;
Bestimmen von Modellausgaben für eine Vielzahl von Modellrealisierungen basierend auf den Eingaben; Clustern der Modellausgaben basierend auf den Modelleingaben;
Identifizieren von Clustern in den Modellausgaben; und
Auswählen einer oder mehrerer repräsentativer Modellrealisierungen aus den einzelnen Clustern.

10. Computersystem (901), umfassend:
einen oder mehrere Prozessoren (904); und
ein Speichersystem (906), umfassend ein oder mehrere nichtflüchtige computerlesbare Medien, die Anweisungen speichern, die, wenn sie durch mindestens einen des einen oder der mehreren Prozessoren (904) ausgeführt werden, das Computersystem (901) veranlassen, Vorgänge durchzuführen, die Vorgänge umfassend die Schritte des Verfahrens nach einem der vorstehenden Ansprüche.

11. Nichtflüchtiges computerlesbares Medium (906), das Anweisungen speichert, die, wenn sie durch mindestens einen Prozessor (904) eines Computersystems (901) ausgeführt werden, das Computersystem (901) veranlassen, Vorgänge durchzuführen, die Vorgänge umfassend das Verfahren nach einem der Ansprüche 1 bis 9.

12. Computerprogramm, umfassend Anweisungen zum Implementieren des Verfahrens nach einem der Ansprüche 1 bis 9.

## Revendications

1. Procédé implémenté par ordinateur, comprenant :
la réception de données représentant une ou plusieurs propriétés de réservoir pour un volume subsurface ;
l'exécution (1002) d'une analyse probabiliste d'incertitude par simulation d'une pluralité de réalisations modèles différentes représentant le volume subsurface ;
l'identification (1008) d'un premier point chaud du volume subsurface en fonction au moins en partie de l'analyse d'incertitude, le premier point chaud représentant une zone ayant une performance de production prédite élevée, par rapport à d'autres zones du volume subsurface, en fonction de la simulation des différentes réalisations modèles représentant le volume subsurface ;
l'identification (1010) d'un second point chaud du volume subsurface à l'aide d'un modèle d'apprentissage automatique mandataire qui est entraîné pour prédire une performance de production de puits à la fois de puits existants et nouveaux en fonction de données de performance historique de production de puits et de propriétés de réservoir et sans simulation d'un modèle basé sur la physique du volume subsurface, dans lequel l'entraînement du modèle d'apprentissage automatique mandataire comprend :
la cartographie de performance historique de production de puits dans un espace vectoriel en fonction d'un ou plusieurs paramètres choisis dans le groupe constitué d'historique de production et d'injection, localisation de puits, données de diagraphie, données de carottage, et propriétés de réservoir ; et
l'identification d'un ou plusieurs groupes dans l'espace vectoriel ; et
la détermination d'une relation entre le ou les paramètres et la performance historique de puits en fonction du ou des groupes identifiés ;
l'évaluation (1022) des premier et second points chauds pour mise en place de puits en fonction au moins en partie de la performance de production de puits prédite au niveau des premier et second points chauds, respectivement ; et
la sélection (1024) d'au moins l'un parmi le premier point chaud ou le second point chaud pour une construction de puits.

2. Procédé selon la revendication 1, comprenant en outre la génération (1014) d'une carte de probabilité du domaine subsurface comportant des représentations du premier point chaud et du second point chaud.

3. Procédé selon la revendication 2, comprenant en outre :
la réception (1006) de données géomécaniques pour le domaine souterrain ; et
la détermination (1012) d'une qualité de complétion pour au moins une portion du volume subsurface en fonction au moins en partie des données géomécaniques,
dans lequel la génération (1014) de la carte de probabilité comprend la génération de la carte de probabilité en fonction au moins en partie de la qualité de complétion.

4. Procédé selon la revendication 1, dans lequel l'évaluation des premier et second points chauds comprend :
la détermination d'une performance de production d'un puits localisé au niveau du premier point chaud et d'une performance de production d'un puits localisé au niveau du second point chaud, d'une performance d'injection d'un puits localisé au niveau du second point chaud, ou de l'une et l'autre, à l'aide d'un modèle d'apprentissage automatique qui est entraîné pour prédire une performance de puits à partir de propriétés de réservoir mesurées.

5. Procédé selon la revendication 1, comprenant en outre :
la réception (902, 904) de données de performance historique de production de puits et de propriétés de réservoir.

6. Procédé selon la revendication 1, dans lequel la carte de probabilité comporte une pluralité de premiers points chauds et une pluralité de seconds points chauds, au moins certains des premiers points chauds étant identiques à au moins certains des seconds points chauds.

7. Procédé selon la revendication 5, comprenant en outre :
la prévision d'une performance de puits localisés au niveau des premiers points chauds, des seconds points chauds, ou des uns et des autres ; et
le classement des premiers points chauds, des seconds points chauds, ou des uns et des autres en fonction de la performance prévue.

8. Procédé selon la revendication 1, comprenant en outre la visualisation d'un modèle numérique du volume subsurface comportant une représentation visuelle de la carte de probabilité, du puits au niveau de la localisation sélectionnée, ou de l'un et l'autre.

9. Procédé selon la revendication 1, comprenant en outre la sélection d'une ou plusieurs réalisations modèles pour exécution de l'analyse d'incertitude, dans lequel la sélection de la ou des réalisations modèles comprend :
la réception d'entrées de modèle et de sorties de modèle ;
la détermination de sorties de modèle pour une pluralité de réalisations modèles en fonction des entrées ; le regroupement des sorties de modèle en fonction des entrées de modèle ;
l'identification de groupes dans les sorties de modèle ; et
la sélection d'une ou plusieurs réalisations modèles représentatives à partir des groupes individuels.

10. Système informatique (901), comprenant :
un ou plusieurs processeurs (904) ; et
un système de mémoire (906) comprenant un ou plusieurs supports non transitoires lisibles par ordinateur stockant des instructions qui, lorsqu'elles sont exécutées par au moins l'un parmi le ou les processeurs (904), amènent le système informatique (901) à mettre en œuvre des opérations, les opérations comprenant les étapes du procédé selon l'une quelconque revendication précédente.

11. Support non transitoire lisible par ordinateur (906) stockant des instructions qui, lorsqu'elles sont exécutées par au moins un processeur (904) d'un système informatique (901), amènent le système informatique (901) à mettre en œuvre des opérations, les opérations comprenant le procédé selon l'une quelconque des revendications 1 à 9.

12. Programme d'ordinateur comprenant des instructions permettant d'implémenter le procédé selon l'une quelconque des revendications 1 à 9.
